# EUROPEAN PATENT APPLICATION

(11) **EP 4 336 541 A1**
(43) Date of publication of application: **13.03.2024**
(21) Application number: 22460041.1
(22) Date of filing: 12.09.2022
(51) Int. Cl.: H01J 37/32, H01J 37/34, C23C 14/34, H03K 3/57, H03K 17/12

(54) **ENERGY REFEEDING MODULE, SWITCHING CIRCUIT AND EMBODIMENT, PLASMA PROCESSING SYSTEM, AND A METHOD OF PRODUCING RECTANGULAR VOLTAGE OUTPUT PULSES FOR A PLASMA PROCESSING LOAD**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

Energy refeeding module (15) for
a switching circuit (101) with a switching unit (24) configured to be connectable to a DC voltage source (V1) and to deliver at its output (OUT) one or a combination of the following features:
iv) high value of voltage,
v) high value of voltage rise with a reduced oscillation and/or overshoot,
vi) high current value to a capacitive load, in particular to a plasma processing load (12),
the energy refeeding module (15) comprising:
c. a rectifying circuit (14) configured to be connected with its positive end of its DC-side to the positive connection of the DC voltage source (V1), with its negative end of its DC-side to the negative connection of the DC voltage source, and
d. a transformer (TF1) comprising:
i. a primary winding (18) configured to be connected in series between the switching unit (24) and the output (OUT), and configured to have both, a stray inductance and parasitic resistance low enough to lead the one or a combination of the following features:
- high value of voltage,
- high value of voltage rise,
- high current value
and
ii. a secondary winding (19) connected to the AC-side of the rectifying circuit (14).

## Description

The invention relates to an energy refeeding module, to a switching circuit comprising such an energy refeeding module, to a switching embodiment comprising at least one of such a switching circuit, a plasma system comprising such a switching circuit and/or a such switching embodiment, and method of producing rectangular voltage output pulses.

Some plasma treatment applications, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required. Therefore, often series connection of such switches is the only possible solution. Series connection requires voltage balancing means. These are not easily realized in HF operation.

Most plasma applications present a load, which contains a capacitive component. Significant power loss is related to the pulse-by-pulse charging and discharging process of this load capacitance. Further problems are low efficiency of pulse generators and unwanted voltage oscillation. Therefore, voltage pulses are required which have an (almost) ideal rectangular shape.

It is the object of the present invention to provide an energy refeeding module, a switching circuit, switching embodiment, plasma processing system and a method for producing high voltage rectangular shape pulses.

The object is solved by an energy refeeding module according to claim 1 and/or a switching circuit according to claim 8 and/or a switching embodiment according to claim 11 and/or a plasma system according to claim 12 and/or a method according to claim 13. Further aspects of the invention are given in the dependent claims and / or the description.

According to one aspect of the invention an energy refeeding module is suggested for a switching circuit with a switching unit configured to be connectable to a DC voltage source and to deliver at its output one or a combination of the following features:
i) high value of voltage,
ii) high value of voltage rise,
iii) high current value to a capacitive load, in particular to a plasma processing load,
the energy refeeding module comprising:
a. a rectifying circuit configured to be connected with its positive end of its DC-side to the positive connection of the DC voltage source, with its negative end of its DC-side to the negative connection of the DC voltage source, in particular to ground potential, and
b. a transformer comprising:
   i. a primary winding configured to be connected in series between the switching unit and the output, and configured to have both, a stray inductance and parasitic resistance low enough to lead the one or a combination of the following features:
      - high value of voltage,
      - high value of voltage rise,
      - high current value
         and
   ii. a secondary winding connected to the AC-side of the rectifying circuit.

According to a further aspect of the invention a switching circuit is suggested, to be connected to a plasma processing load, comprising
- a series connection of a high-side-switching element and a low-side-switching element, the series connection being connected to a voltage source, and configured to generate a high voltage (HV) pulse signal at an output connectable to a plasma load,
- a rectifying circuit connected to the voltage source, and
- a transformer comprising:
   ∘ a primary winding connected in series between the output and a connection point between the high-side-switching element and the low-side-switching element, and
   ∘ a secondary winding connected to the rectifying circuit.

According to a further aspect of the invention a switching circuit is suggested configured to deliver high-voltage- (HV-) fast rising pulses to a plasma processing load, comprising:
a) a switching unit comprising a series connection of a high-side-switching element and a low-side-switching element, a connection point of both switching elements, a low side connection and a high side connection, the low side and high side connections connected to a voltage source,
b) an energy refeeding module as described here, with
   i. the rectifying circuit connected with its DC side to the voltage source, and
   ii. the primary winding of the transformer connected in series between the output and the connection point between the high-side-switching element and the low-side-switching element, and
   iii. the secondary winding connected to the AC-side of the rectifying circuit.

Such a switching circuit allows generating voltage pulses having nearly ideal rectangular shape. In particular, unwanted voltage oscillations can be prevented. Furthermore, the efficiency of such a switching circuit is very high. If such a switching circuit is used in a high voltage pulse generator, the efficiency of the pulse generator can be increased.

The stray inductance may be 100 µH or less. In particular 10 µH or less.

The parasitic resistance may be 1 Ω or less, in particular 0,1 Ω or less.

High value of voltage may be 800 V or more, in particular 1,5 kV or more, especially at least 5 kV.

High value of voltage rise may be a voltage rise of at least 1 kV/µs, in particular 10 kV/µs or more, preferred 100 kV/µs or more. With voltage rise could be meant voltage fall as well.

High current value may be at least 30 A, in particular 100 A or more.

High voltage pulse signal may be a pulse signal with a high voltage as defined above, in particular with a high value of voltage rise as defined above..

The module, the units, the circuit, and/or the embodiment may be configured for a power delivery into the plasma load, in particular during a pulse, at the output of at least 10 kW, advantageously 20 kW or more.

The rectifying circuit may be connected with its positive end of the DC-side to the positive connection of the DC voltage source, with its negative end of the DC-side to the negative connection of the DC voltage source, in particular to ground potential.

The energy refeeding module, the switching circuit, and/or the switching unit may be part of a high power generator as described in EP22461510.4, filed 28.02.2022, with the title "High power generator and method of supplying high power pulses".

The transformer may be a step-up transformer. During generating the pulse the high-side switching element switch may be switched on, so the energy from the voltage source flows to the output connectable to a load, in particular a plasma load having capacitive characteristics. At the beginning of this process almost the entire voltage difference between the voltage source and the voltage on the load occurs on the primary winding of the transformer. At the secondary winding of the transformer a voltage is induced. The value of this voltage is equal to the voltage at the primary winding multiplied by the transformer ratio. If this induced voltage is higher than the supply voltage on the busbar, the rectifying components of the rectifier start to conduct. In this way, the induced voltage at the secondary winding is limited to the value of the voltage on the busbar, i.e. the supply voltage. Because of the transformer ratio, also the voltage at the primary winding is reduced (to a voltage corresponding to the voltage on the busbar divided by the ratio of the transformer). Therefore, at the beginning of charging of the load the transformer represents a relatively low impedance and allows to quickly charge the load. In this state, the transformer's magnetic core does not accumulate any energy, which could cause overvoltage on the load.

When the charging current decreases such that the voltage induced by the secondary winding is not higher than the voltage on the busbar, the current in the secondary winding stops flowing so the transformer merely acts as an inductance. This inductance of the primary winding of the transformer increases, so the current charging the load capacitance decreases. Therefore the charging process decelerates, which reduces unwanted oscillations.

Basically the same occurs when the high-side-switching element is opened and the low-side switching element is closed, i.e. during the falling flank of the output voltage pulse. In that state the energy from the load capacitance is discharged through the low-side-switching element. At the beginning of this process the voltage at the primary winding of the transformer is high enough, that some energy is returned to the busbar by the rectifying circuit.

This process is relatively fast, as the current is limited mainly by the leakage inductance of the transformer. At the end of discharging the capacitive load, the voltage at the primary winding of the transformer is low (the voltage at the secondary winding of the transformer is lower than the voltage at the busbar), so the transformer starts to behave as an ordinary inductance that limits the current and decelerates the discharging process of the load. Once again, the unwanted oscillation is relatively small because the amount of energy stored in the inductance of the transformer is small.

Because for some time some energy is returned back to the busbar and thus to the power source during charging and discharging load capacitance, this circuit has an increased overall efficiency.

The rectifying circuit may comprise one component configured to lead current only in one way, in particular a rectifying diode.

The rectifying circuit may comprise two components configured to lead current only in one way, in particular two rectifying diodes.

The rectifying circuit may comprise four components configured to lead current only in one way, in particular four rectifying diodes, in particular in a bridge circuit. In this way the rectifying circuit can be realized with cheap standard components.

An overvoltage-protecting unit, in particular an overvoltage-protecting diode, may be configured to be connected between the output and the rectifier circuit in order to protect the load against overvoltage.

At least one overvoltage-protecting unit, in particular one overvoltage-protecting diode, may be configured to be connected between the output and at least one connection of the voltage source.

As it was mentioned before, the transformer is charging itself. Therefore, it stores some energy. This can generate some overvoltage (the load capacitance would be charged to a voltage higher than that of the busbar). To avoid this, this overvoltage-protecting unit, in particular overvoltage-protecting diode, can be provided, which protects the load against overvoltage. In this way, unwanted oscillations can be prevented. A first damping resistor may be connected in series to the overvoltage-protecting unit. With that, the energy refeeding module may be even better stabilized. The first damping resistor may have a value from 1 Ω to 100 Ω, preferably from 20 Ω to 70 Ω.

A negative-voltage-protecting unit, in particular a negative-voltage-protecting diode, may be configured to be connected between the output and the ground potential in order to protect the load from negative voltage. Moreover, unwanted oscillations can be limited by adding such a a negative-voltage-protecting unit, in particular a negative-voltage-protecting diode parallel to the load which prevents the load from charging to a negative voltage. A second damping resistor may be connected in series to the negative-voltage-protecting unit. With that, the energy refeeding module may be further stabilized. The second damping resistor may have a value from 1 Ω to 100 Ω, preferably from 20 Ω to 70 Ω.

A diode may be connected in parallel to one, in particular to each of the switching elements. Such, the switching elements may be protected against high voltages. This is particularly true if the switching elements comprise MOSFETS as switching parts. Each switching element may comprise one or more switching parts, for example MOSFETs or bipolar transistors.

One aspect of the invention relates to a switching embodiment with
a. several switching units as described in this description above, comprising in particular a series connection of a high-side-switching element and a low-side-switching element, a connection of both switching elements, a low side connection and a high side connection, the low side and high side connections connected to a voltage source, and
b. at least one switching circuit as described in this description above,
where the switching units are connected in series with one voltage source connection point of one switching circuit connected to the output of the next switching circuit in the series connection line.

A further aspect of the invention relates to a plasma system comprising a plasma load and a switching circuit as described in this description above, and/or a switching embodiment described in this description above. Such a plasma system may be used advantageously in semiconductor production processes, in particular for production of 3D- memory devices, such as 3D NAND-memory devices, preferred when etching deep holes for connection of the 3D-structure.

A further aspect of the invention relates to a method of producing rectangular voltage output pulses comprising the steps of:
- generating a HV pulse signal at an output of a switching circuit using a series connection of a high-side-switching element and a low-side-switching element, the series connection being connected to a voltage source,
- providing the HV pulse signal at the output via a primary winding of a transformer,
- rectifying a current induced in a secondary winding of the transformer.

This method allows generating voltage pulses having nearly ideal rectangular shape. Voltage overshoots and oscillations can be prevented, thus increasing efficiency.

During charging and discharging of a load capacitance connected to the output, energy is fed back to the busbar. This increases the efficiency of the switching circuit. Power loss can largely be prevented.

Oscillations may be reduced by providing diodes connected to the output.

More precise, the oscillations may be reduced by providing
a. an overvoltage-protecting unit, in particular an overvoltage-protecting diode, and/or
b. a negative-voltage-protecting unit, in particular a negative-voltage-protecting diode connected to the output (OUT),
and in particular further reduced by a first and/or a second damping resistor connected in series to the protecting units, in particular the diodes, respectively.

Further features and advantages of the invention result from the following detailed description of embodiments of the invention on the basis of the figures of the drawing, which show details essential to the invention, as well as from the claims. The features shown there are not necessarily to be understood as being to scale and are shown in such a way that the special features according to the invention can be made clearly visible. The various features can be implemented individually or in any combination in variants of the invention.

In the schematic drawing, examples of the invention in various stages of use are shown and explained in more detail in the following description.
- Fig. 1: shows a first example of a plasma processing system with a switching circuit and with an energy refeeding module,
- Fig. 2: shows an output voltage obtained with the inventive switching circuit,
- Fig. 3a, 3b 4a, 4b: show additional examples of a plasma processing systems each with series combination of switching circuits comprising one or several energy refeeding modules,
- Fig 5a: shows the pictures of Fig. 1 and Fig 2 together in a simplified presentation
- Fig 5b - 5d: show related possibilities of Fig. 5a.

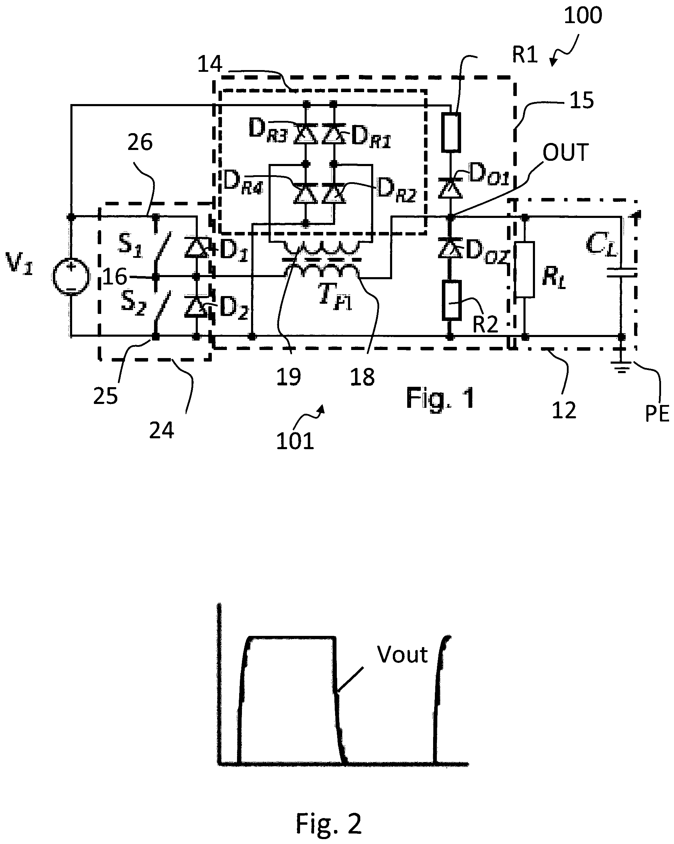

Fig. 1 shows a first example of a plasma processing system 100 with a plasma processing load 12, a switching circuit 101 comprising an energy refeeding module 15 and a switching unit 24 both connected to a DC voltage source V1. The switching circuit 101 is configured to deliver at its output OUT a high value of voltage, high value of voltage rise and/or high current value to a capacitive load, in particular to a plasma processing load 12. The plasma processing load 12 comprises a resistive component R_{L} and a capacitive component C_{L}. A typical value for the resistive component R_{L} is a value between 0,5 kΩ and 50 kΩ. A typical value for the capacitive component C_{L} is a value between 0,1 µF and 1 µF. This may be a plasma load similar or identical as described in the European

Patent Application with the application number EP22461510.4, filed 28.02.2022, with the title "High power generator and method of supplying high power pulses" which shall be integrated into this application with its entirety by reference. The plasma processing system 100 described here may be similar or identical as the one described in Fig. 10 of EP22461510.4, e.g.. The switching unit 24 comprises a series connection of a high-side-switching element S1 and a low-side-switching element S2 and may be similar or identical as the switching units 24, 26, 28 in EP22461510.4. The switching unit 24 may be connected with its positive end 26 to the positive connection of the DC voltage source V1 and with its negative end 25 to the negative connection of the DC voltage source V1, in particular to ground potential PE.

The switching circuit 101 further comprises an energy refeeding module 15. The energy refeeding module 15 is connected with its positive end to the positive connection of the DC voltage source V1 and with its negative end to the negative connection of the DC voltage source V1. The energy refeeding module 15 is further connected to the connection point 16 between the high-side-switching element S1 and the low-side-switching element S2. The energy refeeding module 15 is further connected with the output OUT of the switching circuit 101.

The energy refeeding module 15 comprises a rectifying circuit 14 and a transformer TF1. The rectifying circuit 14 is connected with its positive end of the DC-side to the positive connection of the DC voltage source V1 and with its negative end of the DC-side to the negative connection of the DC voltage source V1, here in particular to ground potential PE. The transformer TF1 comprises a primary winding 18 and a secondary winding 19. The primary winding 18 is connected in series between the output OUT of the switching circuit 101 and the switching unit 24, in particular the connection point 16 between the high-side-switching element S1 and the low-side-switching element S2. The transformer TF1 is configured to have both, a stray inductance and parasitic resistance low enough to lead the afore mentioned high value of voltage, high value of voltage rise, and/or high current value. The secondary winding 19 of the transformer TF1 is connected with both ends to the AC-side of the rectifying circuit 14. The rectifying circuit 14 comprises four diodes DR1-DR4 connected here in a bridge circuit. The rectifying circuit 14 is connected with its DC-side to the voltage source V1 and with its AC-side to a secondary winding of a transformer TF1. The transformer TF1 may comprise a magnetic core.

Diodes D1, D2 are provided in parallel to each of the switching elements S1, S2. They may be used as freewheeling diodes and/or to protect the switching elements S1, S2 against negative voltage.

An overvoltage protection unit, embodied as a further diode D01, is connected between the output OUT and the positive connection of the voltage source V1 to protect the load against overvoltage. A negative-voltage-protecting unit, embodied as an other diode D02, is connected between the negative connection of the voltage source V1, here in particular ground potential PE, and the output OUT, i.e. in parallel to the load 12, in order to protect the load from negative voltages. These diodes D01, D02 may also reduce oscillations. Further, a first damping resistor R1 is connected in series with the overvoltage protection unit, embodies as diode D01. Further, a second damping resistor R2 is connected in series with the negative-voltage-protecting unit, embodied as diode D02. With these resistors oscillations may be reduced even better.

The operation of the switching circuit 101 is as follows. During generating of a pulse, high-side switching element S1 may be switched on so that energy from the voltage source V1 flows to the output OUT. At the beginning of this process almost the entire voltage difference between the voltage source V1 and the voltage on the load 12 occurs on the primary winding of the transformer TF1. Therefore, a voltage will be induced at the secondary winding 19 of the transformer TF1. The value of this voltage is equal to the voltage at the primary winding multiplied by the transformer ratio. If this induced voltage is higher than the voltage on the voltage source V1, the positively biased diodes DR1-DR4 of the rectifier 14 start to conduct, therefore the induced voltage at the secondary winding is limited to the value of the voltage of the voltage source V1. Because of the transformer ratio, also the voltage at the primary winding is reduced, to a voltage corresponding to the voltage on the voltage source V1 divided by the ratio of the transformer. Therefore, at the beginning of charging of the load 12 the transformer TF1 represents a relatively low impedance and allows to quickly charge the load 12. In this state, the transformer's magnetic core does not accumulate any energy, which may cause overvoltage on the load 12.

When the charging current decreases such that the voltage induced by the secondary winding is not higher than the voltage on the busbar V1, the current in the secondary winding stops flowing, so the transformer TF1 merely acts as an inductance. This inductance of the primary winding of transformer TF1 increases, so the current charging the load 12 decreases. Therefore, the charging process decelerates which reduces unwanted oscillations.

The same occurs when high-side switching element S1 is opened and low-side switching element 2 is closed, i.e. during the falling flank of the output voltage pulse. In that state the energy from the load is discharged through low-side switching element S2. At the beginning of this process the voltage at the primary winding of the transformer TF1 is high enough, that some energy is returned to the voltage source V1 by the rectifying circuit 14.

This process is relatively fast, as the current is limited mainly by the leakage inductance of the transformer TF1. At the end of discharging the load, the voltage at the primary winding of the transformer TF1 is low (the voltage at the secondary winding of the transformer TF1 is lower than the voltage at the voltage source V1). So, the transformer TF1 starts to behave as an ordinary inductance that limits the current and decelerates the discharging process of the load 12. Once again, the unwanted oscillation is relatively small because the amount of energy stored in the inductance of the transformer TF1 is small.

Fig. 2 shows a voltage waveform VOUT generated by switching circuit 101 at its output OUT. As can be seen, a rectangular voltage pulse is obtained, having steep flanks and no oscillations at the corners of the pulse shape.

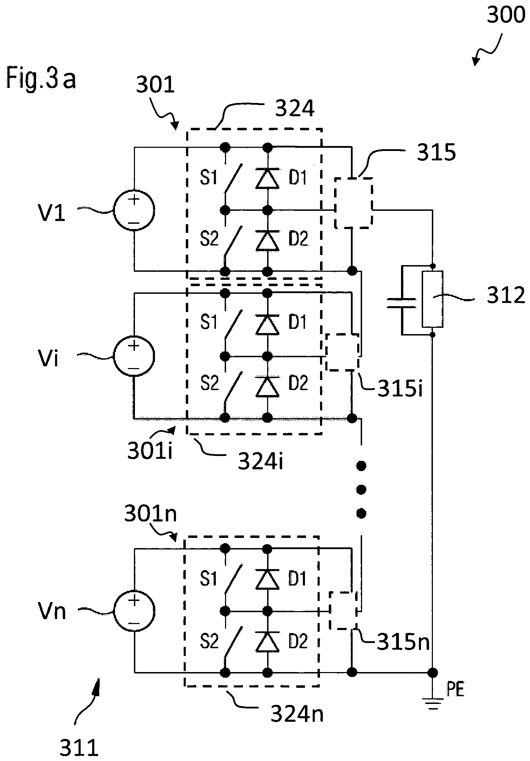

Fig. 3a shows a second example of a plasma processing system 300 with series combination of switching circuits 301, 301i,... 301n comprising an energy refeeding module 315, 315i,... 315n, and a switching unit 324,... 324i, 324n, each.

Every switching unit 324, 324i,... 324n, is connected to a corresponding voltage source V1, Vi,... Vn, respectively.

The series combination of switching circuits 301, 301i,... 301n may build a switching embodiment 311.

The switching units 324, ... 324i, ... 324n are connected in series with one voltage source connection point of one switching circuit 301, 301i connected to the output OUT of the next switching circuit 301i, 301n in the series connection line.

The refeeding modules 315i,... 315n are here optional. For the effect only one refeeding module 315 at the output of the switching embodiment 311 may be sufficient.

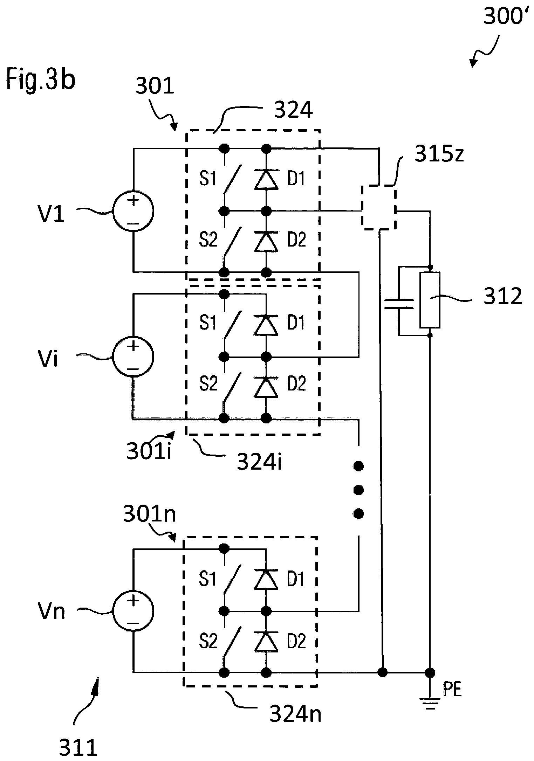

Fig. 3b shows a third example of a plasma processing system 300' with series combination of switching circuits 301, 301i,... 301n. In comparison to Fig. 3a the plasma processing system 300' comprises only one energy refeeding module 315z which is connected to the output of one of the switching circuits 301, to a voltage source V1 of a switching circuit 301, in particular to this switching circuit 301, and to a different voltage source Vn of a switching circuit 301n, in particular to ground potential PE.

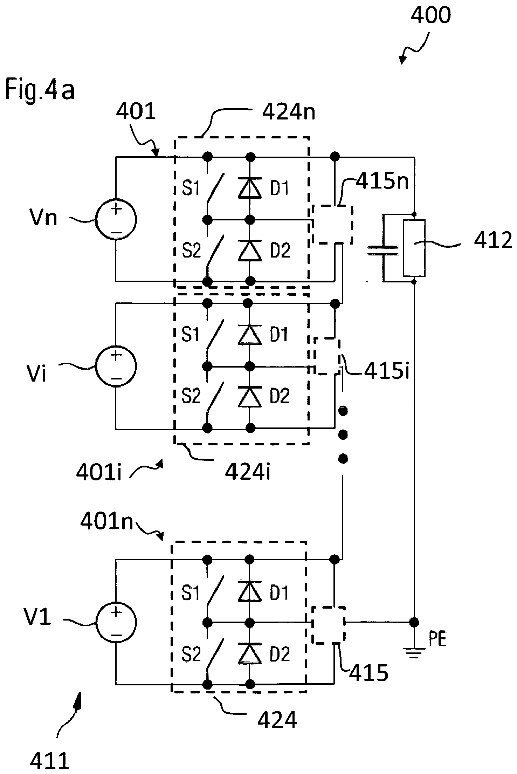

Fig. 4a shows a forth example of a plasma processing system 400 with series combination of switching circuits 401, 401i,... 401n comprising an energy refeeding module 415, 415i,... 415n, and a switching unit 424,... 424i, 424n, each.

Every switching unit 424, 424i,... 424n, is connected to a corresponding voltage source V1, Vi,... Vn, respectively.

The series combination of switching circuits 401, 401i,... 401n may build a switching embodiment 411.

The switching units 424, ... 424i, ... 424n are connected in series with one voltage source connection point of one switching circuit 401n, 401i connected to the output OUT of the next switching circuit 401i, 401 in the series connection line.

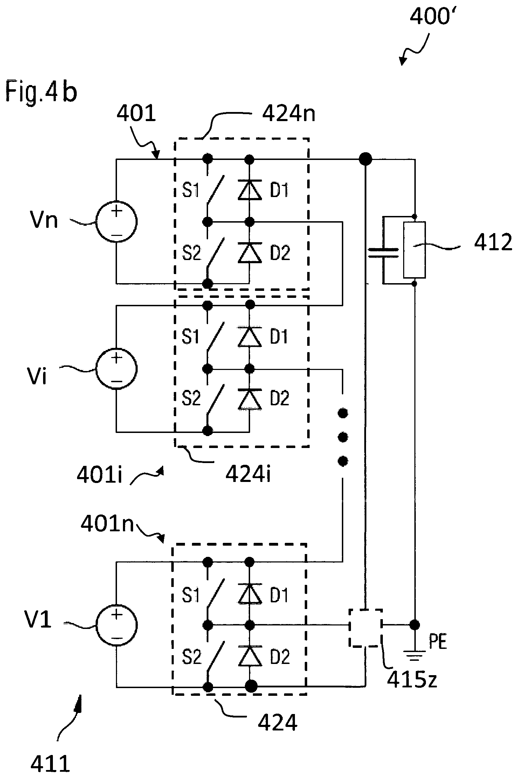

The refeeding modules 415i,... 415n are here optional. For the effect only one refeeding module 415 at the output of the switching embodiment 411 may be sufficient. A switching embodiment 411 with such a realization is shown in Fig. 4b, where the plasma processing system 400' has only one energy refeeding module 415z.

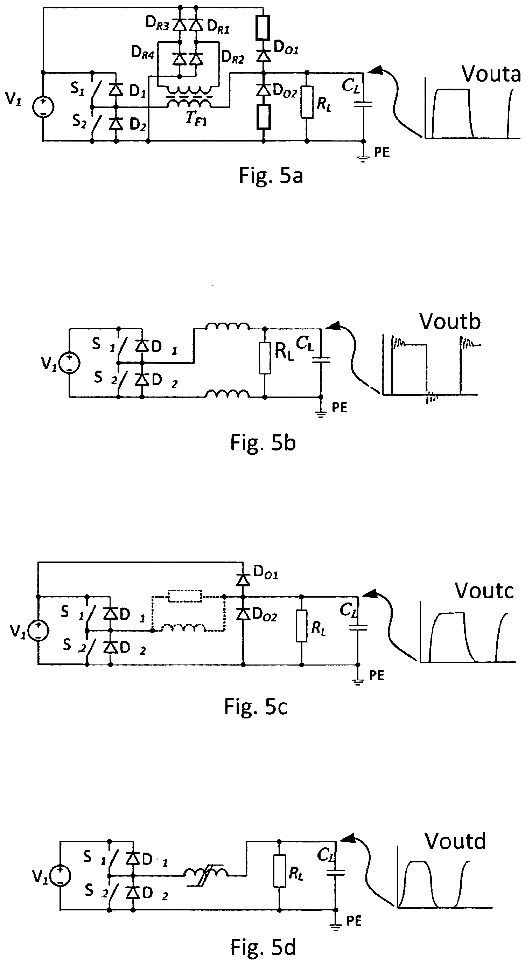

In Fig 5a - 5d the advantage of the energy refeeding module 15, 315, 415, the switching circuit 24, 324, 424 comprising such an energy refeeding module, the switching embodiment 311, 411 comprising at least one of such a switching circuit 324, 424, the plasma system 100, 300, 400 comprising such a switching circuit and/or a such switching embodiment, and the method of producing rectangular voltage output pulses should become more visible.

Fig 5a shows the pictures of Fig. 1 and Fig 2 together in a simplified presentation.

Fig 5b - 5d show related possibilities of Fig. 5a with corresponding output voltages Voutb, Voutc, Voutd. The voltage swing may be of about 8 kV or more. The current, which is not shown, at the same time may be of about 30 A or more. The duration of such a pulse may be of 0,5 µs up to 2 µs. So, the rise times of the voltage may be about 300 ns or shorter. It can easily be seen that Vouta rises much faster than the voltages Voutc, Voutd in the corresponding circuits and systems of Fig. 5c and Fig. 5d. So, the module, circuit, embodiment, and system of Fig. 5a has advantages compared to the circuits in Fig 5c and Fig. 5d. Further, it can easily be seen that Vouta rises not faster than the voltages Voutb in the corresponding circuits and systems of Fig. 5b. But, the voltage Voutb in Fig. 5b shows a significant overvoltage swing, which the voltage Vouta does not show in Fig. 5a. So, the module, circuit, embodiment, and system of Fig. 5a has advantages related to fast switching with reduced overshoot and reduced oscillations compared also to the circuit in Fig 5b.

## Claims

1. Energy refeeding module (15) for
a switching circuit (101) with a switching unit (24) configured to be connectable to a DC voltage source (V1) and to deliver at its output (OUT) one or a combination of the following features:
i) high value of voltage,
ii) high value of voltage rise,
iii) high current value to a capacitive load, in particular to a plasma processing load (12),
the energy refeeding module (15) comprising:
a. a rectifying circuit (14) configured to be connected with its positive end of its DC-side to the positive connection of the DC voltage source (V1), with its negative end of its DC-side to the negative connection of the DC voltage source (V1), in particular to ground potential (PE), and
b. a transformer (TF1) comprising:
i. a primary winding (18) configured to be connected in series between the switching unit (24) and the output (OUT), and configured to have both, a stray inductance and parasitic resistance low enough to lead the one or a combination of the following features:
- high value of voltage,
- high value of voltage rise,
- high current value
and
ii. a secondary winding (19) connected to the AC-side of the rectifying circuit (14).

2. Energy refeeding module (15) according to claim 1, wherein the transformer (TF1) is a step-up transformer.

3. Energy refeeding module (15) according to any of the preceding claims, wherein the rectifying circuit (14) comprises two components configured to lead current only in one way, in particular two rectifying diodes (DR1, DR3), in particular four components configured to lead current only in one way, in particular four rectifying diodes (DR1-DR4), in particular in a bridge circuit.

4. Energy refeeding module (15) according to any of the preceding claims, wherein an overvoltage-protecting unit, in particular overvoltage-protecting diode (D01) is configured to be connected between the output (OUT) and the positive end of the DC-Side of the rectifier circuit (14) in order to protect the load (12) against overvoltage.

5. Energy refeeding module (15) according to claim 4 with a first damping resistor R1 connected in series with the overvoltage-protecting unit.

6. Energy refeeding module (15) according to any of the preceding claims, wherein a negative-voltage-protecting unit, in particular a negative-voltage-protecting diode (D02), is configured to be connected between the output (OUT) and the negative connection of the voltage source (V1) in particular to ground potential (PE), in order to protect the load (12) from negative voltage.

7. Energy refeeding module (15) according to claim 6 with a second damping resistor (R2) connected in series with the negative-voltage- -protecting unit.

8. Switching circuit (101, 301, 401) configured to deliver high-voltage- (HV-) fast rising pulses to a plasma processing load (12), comprising:
a. a switching unit (24) comprising a series connection of a high-side-switching element (S1) and a low-side-switching element (S2), a connection point (16) of both switching elements (S1, S2), a low side connection (25) and a high side connection (26), the low side and high side connections (25, 26) connected to a voltage source (V1),
b. an energy refeeding module (15) of one of the preceding claims, with
i. the rectifying circuit (14) connected with its DC side to the voltage source (V1), and
ii. the primary winding (18) of the transformer (TF1) connected in series between the output (OUT) and the connection point (16) between the high-side-switching element (S1) and the low-side-switching element (S2), and
iii. the secondary winding (19) connected to the AC-side of the rectifying circuit (14).

9. Switching circuit (101, 301, 401) according to claim 8, wherein a diode (D1, D2) is connected in parallel to one, in particular to each, of the switching elements (S1, S2).

10. Switching circuit (101, 301, 401) according to any of the preceding claims 8 or 9, wherein at least one overvoltage-protecting unit, in particular one diode (D01, D02), is connected between the output (OUT) and at least one connection of the voltage source (V1).

11. Switching embodiment (311, 411) with
a. several switching units (324, ... 324i, ... 324n, 425, ...324i, ...324n) according to feature a. of claim 8, and
b. at least one switching circuit (301) according to one of the preceding claims 8 - 10,
c. where the switching units (324, ... 324i, ... 324n, 424 ...424i, ...424n) are connected in series with one voltage source connection point of one switching circuit (301, 301i, 401i, 401n) connected to the output (OUT) of the next switching circuit (301i, 301n, 401, 401i) in the series connection line.

12. Plasma system (100, 300, 400) comprising a plasma load (12, 312, 412) and
a. a switching circuit (101, 301, 401) according to one of the preceding claims 8 - 10, and/or
b. a switching embodiment (311, 411) according to claim 11.

13. Method of producing rectangular voltage output pulses (Vout) for a plasma processing load (12) comprising the steps of
a. Generating a high- voltage- (HV-) pulse signal at an output (OUT) of a switching circuit (10) using a series connection of a high-side-switching element (S1) and a low-side-switching element (S2), the series connection being connected to a voltage source (V1),
b. Providing the HV pulse signal at the output (OUT) via a primary winding of a transformer (TF1),
c. rectifying a current induced in a secondary winding of the transformer (TF1).

14. Method according to claim 13, wherein during charging and discharging of a load capacitance connected to the output (OUT), energy is fed back to the busbar (V1).

15. Method according to one of the claims 13 or 14, wherein oscillations are reduced by providing
a. an overvoltage-protecting unit, in particular an overvoltage-protecting diode (D01), and/or
b. a negative-voltage-protecting unit, in particular a negative-voltage-protecting diode (D02) connected to the output (OUT), and
in particular further reduced by a first and/or a second damping resistor (R1, R2) connected in series to the protecting units, in particular the diodes (D01, D02), respectively.
